# EUROPEAN PATENT APPLICATION

(11) **EP 1 283 573 A2**
(43) Date of publication of application: **12.02.2003**
(21) Application number: 02255176.6
(22) Date of filing: 24.07.2002
(51) Int. Cl.: H01S 5/125

(54) **A distributed bragg reflector semiconductor laser**

(30) Priority: 27.07.2001 JP 2001228669; 15.03.2002 US 364034 P
(71) Applicant: THE FURUKAWA ELECTRIC CO., LTD., Tokyo 100-8322 (JP)
(72) Inventor: Yoshida, Junji, THe Furukawa Electric Co., Ltd., Tokyo 100-8322 (JP); Tsukiji, Naoki, THe Furukawa Electric Co., Ltd., Tokyo 100-8322 (JP)
(74) Representative: Nicholls, Michael John

(57) **Abstract**

A semiconductor device for providing a light source suitable for use as a pumping light source in a Raman amplification system. The device includes a light reflecting facet positioned on a first side of the semiconductor device, a light emitting facet positioned on a second side of the semiconductor device thereby forming a resonator between the light reflecting facet and the light emitting facet. An active layer configured to radiate light in the presence of an injection current is positioned within the resonator along a portion of the resonator length, and a wavepath layer is positioned adjacent to the active layer within a remaining portion of the resonator length. The wavepath layer includes a diffraction grating configured to select a spectrum of light including multiple longitudinal modes.

## Description

### CROSS REFERENCE TO RELATED APPLICATIONS

This application includes subject matter related to U.S. Patent Application Numbers 09/832,885 filed April 12, 2001, 09/983,175 filed on October 23, 2001, and 09/983,249 filed on October 23, 2001, assigned to The Furukawa Electric Co., Ltd. And the entire contents of these applications are incorporated herein by reference.

### FIELD OF THE INVENTION

The present invention relates generally to semiconductor laser device, and in particular to a semiconductor laser device used as a pumping source for an optical amplifier.

### BACKGROUND OF THE INVENTION

With the proliferation of multimedia features on the Internet in the recent years, there has arisen a demand for larger data transmission capacity for optical communication systems. Conventional optical communication systems transmitted data on a single optical fiber at a single wavelength of 1310 nm or 1550 nm, which have reduced light absorption properties for optical fibers. However, in order to increase the data transmission capacity of such single fiber systems, it was necessary to increase the number of optical fibers laid on a transmission route, which resulted in an undesirable increase in costs.

In view of this, there has recently been developed wavelength division multiplexing (WDM) optical communications systems such as the dense wavelength division multiplexing (DWDM) system wherein a plurality of optical signals of different wavelengths can be transmitted simultaneously through a single optical fiber. These systems generally use an Erbium Doped Fiber Amplifier (EDFA) to amplify the data light signals as required for long transmission distances. WDM systems using EDFA initially operated in the 1550 nm band which is the operating band of the Erbium Doped Fiber Amplifier and the band at which gain flattening can be easily achieved. While use of WDM communication systems using the EDFA has recently expanded to the small gain coefficient band of 1580 nm, there has nevertheless been an increasing interest in an optical amplifier that operates outside the EDFA band because the low loss band of an optical fiber is wider than a band that can be amplified by the EDFA; a Raman amplifier is one such optical amplifier.

In a Raman amplifier system, a strong pumping light beam is pumped into an optical transmission line carrying an optical data signal. As is known to one of ordinary skill in the art, a Raman scattering effect causes a gain for optical signals having a frequency approximately 13THz smaller than the frequency of the pumping beam. Where the data signal on the optical transmission line has this longer wavelength, the data signal is amplified. Thus, unlike an EDFA where a gain wavelength band is determined by the energy level of an Erbium ion, a Raman amplifier has a gain wavelength band that is determined by a wavelength of the pumping beam and, therefore, can amplify an arbitrary wavelength band by selecting a pumping light wavelength. Consequently, light signals within the entire low loss band of an optical fiber can be amplified with the WDM communication system using the Raman amplifier and the number of channels of signal light beams can be increased as compared with the communication system using the EDFA.

For the EDFA and Raman amplifiers, it is desirable to have a high output laser device as a pumping source. This is particularly important for the Raman amplifier, which amplifies signals over a wide wavelength band, but has relatively small gain. Such high output is generally provided by a pumping source having multiple longitudinal modes of operation. The Furukawa Electric Co., Ltd. has recently developed an integrated diffraction grating device that provides a high output laser beam suitable for use as a pumping source in a Raman amplification system. An integrated diffraction grating device, as opposed to a fiber brag grating device, includes the diffraction grating formed within the semiconductor laser device itself. Examples of integrated diffraction grating devices are disclosed in U.S. Patent Application Numbers 09/832,885 filed April 12, 2001, 09/983,175 filed on October 23, 2001, and 09/983,249 filed on October 23, 2001, assigned to The Furukawa Electric Co., Ltd. the entire contents of these applications are incorporated herein by reference. While the integrated diffraction grating devices disclosed in these applications provide an improved pumping source for optical amplifiers, the devices are primarily directed to a diffraction grating positioned along the gain region. The present inventors have realized, however, that these devices have a limited design margin because the grating parameters are limited by the material used to form the gain region.

### SUMMARY OF THE INVENTION

An object of the present invention is to provide an integrated diffraction grating device having an improved design margin.
Another object of the present invention is to provide an integrated diffraction grating device having a stable and efficient light output.

According to a first aspect of the present invention, a semiconductor device for providing a light source suitable for use as a pumping light source in a Raman amplification system is provided. The device includes a light reflecting facet positioned on a first side of the semiconductor device, a light emitting facet positioned on a second side of the semiconductor device thereby forming a resonator between the light reflecting facet and the light emitting facet. An active layer configured to radiate light in the presence of an injection current is positioned within the resonator along a portion of the resonator length, and a wavepath layer is positioned adjacent to the active layer within a remaining portion of the resonator length. The wavepath layer includes a diffraction grating configured to select a spectrum of light including multiple longitudinal modes.

The wavepath layer may be positioned adjacent to either the light emitting facet or the light reflecting facet. In one embodiment, an injection current electrode is positioned along the active layer and configured to input the injection current. The current electrode does not extend a significant distance into the remaining portion of the resonator length. A phase adjustment layer may also be positioned within the resonator along a portion of the resonator length interposed between the active layer and the wavepath layer. The current electrode also does not extend a significant distance into the portion of the resonator length interposed between the active layer and the wavepath layer.

The diffraction grating includes a plurality of grating elements having a constant period. The diffraction grating may include a chirped grating having a plurality of grating elements having fluctuating periods. A fluctuation in the period of the plurality of grating elements may be a random fluctuation.

In a second aspect of the invention, a semiconductor laser module, optical amplifier, and wavelength division multiplexing system is provided with a semiconductor laser device including a light reflecting facet positioned on a first side of the semiconductor device, and a light emitting facet positioned on a second side of the semiconductor device thereby forming a resonator between the light reflecting facet and the light emitting facet. An active layer configured to radiate light in the presence of an injection current is positioned within the resonator along a portion of the resonator length, and a wavepath layer is positioned adjacent to the active layer within a remaining portion of the resonator length. The wavepath layer includes a diffraction grating configured to select a spectrum of light including multiple longitudinal modes. The optical amplifier may be a Raman amplifier with the semiconductor laser device coupled to a fiber such that the light beam of the laser device is applied in a forward and/or backward pumping method.

### BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:
Figure 1 is a vertical sectional view in the longitudinal direction of a semiconductor laser according to a first embodiment of the present invention;
Figure 2 is a cross sectional view along the line A-A of the semiconductor laser device shown in Figure 1;
Figure 3 is a cross sectional view along the line B-B of the semiconductor laser device shown in Figure 1;
Figure 4 shows the oscillation wavelength spectrum of a diffraction grating semiconductor laser device in accordance with the present invention;
Figure 5 is a vertical sectional view in the longitudinal direction of a semiconductor laser device according to a second embodiment of the present invention;
Figure 6 is a vertical sectional view in the longitudinal direction of a semiconductor laser device according to a third embodiment of the present invention.
Figure 7 is a vertical sectional view in the longitudinal direction of a semiconductor laser device according to a fourth embodiment of the present invention;
Figure 8A is a graph illustrating the principle of a composite oscillation wavelength spectrum produced by the combined period _{Λ1} and _{Λ2} of Figure 7.
Figure 8B illustrates a periodic fluctuation of the grating period of a chirped diffraction grating in accordance with the present invention;
Figures 9A through 9C illustrate examples for realizing the periodic fluctuation of the diffraction grating in accordance with the present invention;
Figure 10 is a cross sectional view of a semiconductor laser device having a diffraction grating embedded in the cladding layer in accordance with the present invention;
Figure 11 is a vertical sectional view illustrating a configuration of a semiconductor laser module in accordance with the present invention;
Figure 12 is a block diagram illustrating a configuration of a Raman amplifier in which polarization dependency is canceled by polarization-multiplexing of pumping light beams output from two semiconductor laser devices, in accordance with an embodiment of the present invention;
Figure 13 is a block diagram illustrating a configuration of a Raman amplifier in which polarization dependency is canceled by depolarizing a pumping light beam output from a single semiconductor laser device using polarization maintaining fibers as a depolarizer, in accordance with an embodiment of the present invention; and
Figure 14 is a block diagram illustrating a general configuration of a WDM communication system in which the Raman amplifier shown in Figures 16 and 17 are used.

### DESCRIPTION OF THE PREFERRED EMBODIMENTS

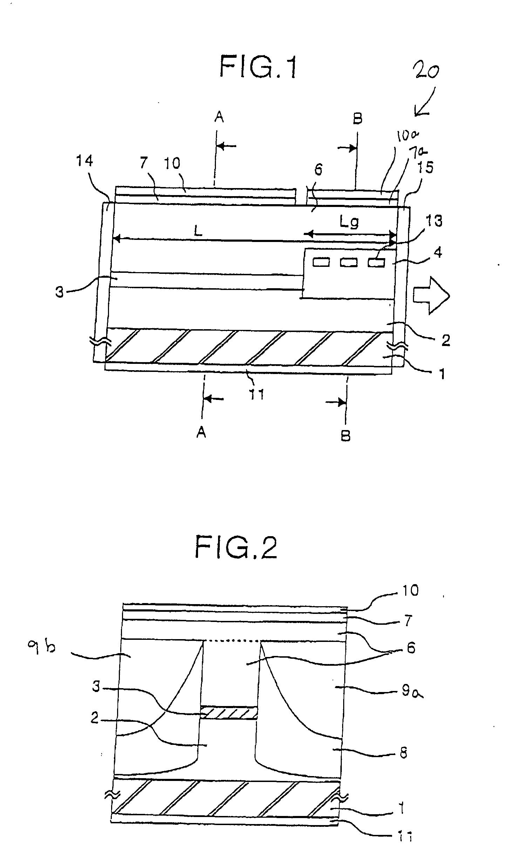

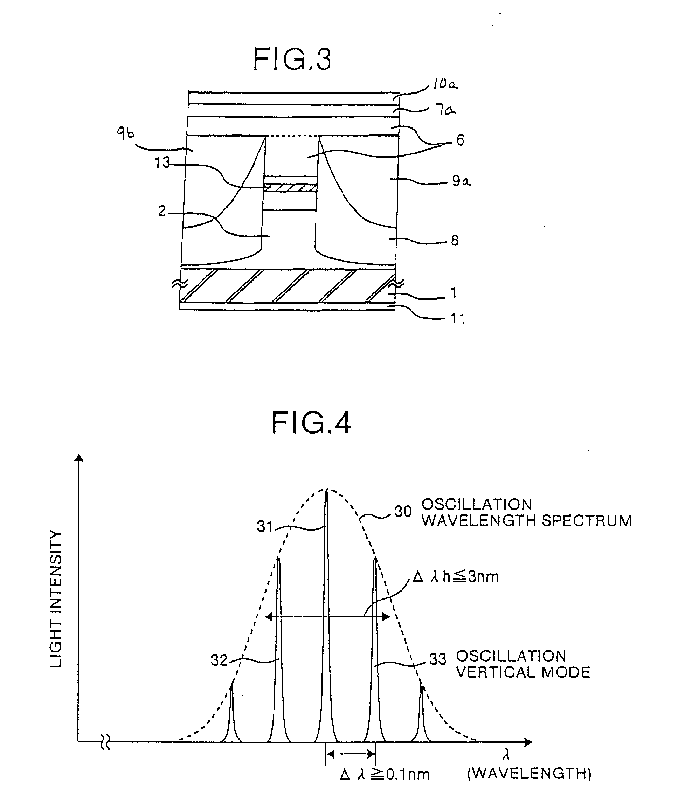

Referring now to the drawings wherein like elements are represented by the same reference designation throughout, and more particularly to Figures 1-3 thereof, there is shown a semiconductor laser device for providing a wavelength tunable light source suitable for use as a pumping light source in a Raman amplification system. Figure 1 is a vertical sectional view in the longitudinal direction of the semiconductor laser device in accordance with a first embodiment of the present invention, Figure 2 is a cross sectional view of the semiconductor laser device, taken along the line A-A in Figure 1, and Figure 3 is a cross sectional view of the semiconductor laser device, taken along the line B-B in Figure 1.

The semiconductor laser device 20 of Figures 1-3 includes an active region for generating light by radiation recombination, and a wavelength selection region for determining a wavelength of the light output from the laser device 20. The active region is situated on the left side of the device illustrated in Figure 1 and includes an n-InP substrate 1 having an n-InP buffer layer 2, an active layer 3, a p-InP cladding layer 6, and p-InGaAsP contact layer 7 sequentially stacked on a face (100) of the substrate 1. Buffer layer 2 serves both as a buffer layer by the n-InP material and an under cladding layer, while the active layer 3 is a graded index separate confinement multiple quantum well (GRIN-SCH-MQW) having a compression strain. In a preferred embodiment, the MQW structure includes five wells having a 1% compression strain. However, where the strain amount is 1.5% or larger, a strain compensated MQW structure having a barrier layer with a tensile strain is preferrable to reduce the strain energy stored in the MQW.

The wavelength selection region is situated on the right side of the device illustrated in Figure 1 and includes the n-InP substrate 1 having the n-InP buffer layer 2, a GaInAsP light guiding wavepath layer 4, and p-InP cladding layer 6, sequentially stacked on a face (100) of the substrate 1. As shown in Figure 1, a p-InGaAsP contact layer 7a may optionally be provided in the wavelength selection region where this region will be used for wavelength tuning as will be further discussed below. A diffraction grating 13 of a p-InGaAsP material is periodically formed within the wavepath layer 4. The diffraction grating 13 of the embodiment of Figure 1 has a length Lg of approximately 250 µm, a film thickness of 20 nm, a period of 220 nm, and selects a laser beam having a central wavelength of 1480 nm to be emitted by the semiconductor laser device 20. It is desirable that the grating material of the diffraction grating 13 be placed in contact with the emission side reflective film 15. However, it is not absolutely necessary for the grating to contact the film 15, and it is also possible for the grating to be placed within the range where it fulfills the wavelength selection function of the diffraction gratings 13. For example, the grating material may be placed at a distance from the emission side reflective membrane 15 that is within the range of approximately 20 µm to 100 µm.

As best seen in Figures 2 and 3, the wavepath layer 4 having the diffraction grating 13, the GRIN-SCH-MQW active layer 3, and the upper part of the n-InP buffer layer 2 are processed in a mesa strip shape. The sides of the mesa strip are buried by a p-InP blocking layer 9b and an n-InP blocking layer 9a formed as current blocking layers. In addition, a p-side electrode is formed on the upper surface of InGaAsP contact layer 7, and an n-side electrode 11 is formed on the back surface of n-InP substrate 1. The p-side electrode includes an electrode 10 formed on the upper surface of the contact region 7 in the active region of the device, and an electrode 10a is optionally formed on the upper surface of the contact region 7a to provide wavelength tuning for the wavelength selection region of the device as noted above.

As seen in Figure 1, reflective film 14 having high reflectivity of, for example, 80% or more, and preferably 98% or more is formed on a light reflecting end surface that is one end surface in the longitudinal direction of the semiconductor laser device 20. Antireflection coating 15 having low reflectivity of, for example, less than 2% and preferably less than .1%, is formed on a light irradiating end surface opposing the light reflecting end surface of semiconductor laser device 20. The reflective film 14 and the diffraction grating region including the antireflection coating 15 form a light resonator within the active region 3 of the semiconductor laser device 20. The resonator length L is preferably from 800 µm - 3200 µm in order to provide multiple longitudinal modes within the oscillation spectrum profile of the laser device, A light beam generated inside the GRIN-SCH-MQW active layer with compression strain 3 of the light resonator is reflected by the reflective film 14 and irradiated as an output laser beam via the antireflection coating 15. The light is emitted after undergoing wavelength selection by the diffraction grating 13 provided within the light guiding wavepath layer 4.

Figure 4 shows the oscillation wavelength spectrum of the light output of a diffraction grating semiconductor laser device in accordance with the present invention. As seen in this figure, the oscillation wavelength spectrum 30 provides multiple longitudinal modes, for example 31, 32, and 33, separated by a wavelength interval Δλ. Patent Application Nos. 09/832,885, 09/983,175 and 09/983,249 disclose various methods for providing stable multiple longitudinal modes within the oscillating spectrum to achieve higher output power. While the techniques of these applications are applicable to the present invention, the present invention improves on these devices in several ways. Specifically, the integrated diffraction grating devices of the 09/832,885, 09/983,175 and 09/983,249 applications have a diffraction grating formed along an active region between the active region and the p-side electrode in a distributed feedback (DFB) configuration. The present inventors have discovered that such a DFB configuration limits the design margin of grating parameters such as the selected wavelength, grating length, and coupling coefficient. The limitation is due to the spacer material that the grating is placed in, and the grating material itself being selected based on laser gain considerations because the grating is in the gain region of the laser. Optimizing such gain consideration may have a negative effect on the grating parameters. The present inventors have discovered that placing the grating in a distributed Bragg reflector (DBR) configuration where the grating is outside the gain region in accordance with the present invention allows the materials used for the grating structure to be selected without regard to gain considerations. Specifically, the materials 4 and 13 in Figure 1 may be selected to optimize the grating parameters of selected wavelength, grating length, and coupling coefficient.

In addition to the reduced design margin of the DFB configuration, the present inventors have recognized that current changes within the area of the diffraction grating 13 changes the wavelength selection characteristics of the laser device. This is mainly due to temperature variations that change the refractive index of the diffraction grating, but a plasma effect wherein current density changes affect the refractive index also contribute to the problem. Therefore, with the configuration of the 09/832,885, 09/983,175 and 09/983,249 applications, changes in the injection current of the active region to change the light output of the device also change the wavelength selection characteristics of the diffraction grating causing undesirable wavelength shifts.

The present inventors have discovered that by separating the active region from the wavelength selection region as shown in Figure 1, a more stable and efficient output can be achieved. Specifically, because the diffraction grating 13 is placed within the wavepath layer 4 in front of the active layer 3 where no p-side electrode normally exists, rather than along the active layer where an electrode provides injection current, the wavelength selection region acts as a passive device preventing undesirable wavelength shifts that occur due to changes in the active region injection current. Moreover, in the embodiment where the active region and the wavelength selection region have independent p-side electrodes, these portions of the device can be current controlled separately. That is, the injection current to the active region of the device can be controlled to affect the light output, while the injection current to the wavelength selection region can be controlled to affect wavelength selection thereby providing a tunable laser. In this regard, the materials of the wavepath layer 4 and the diffraction grating 13 can be selected according to how the refractive index of these materials change for different current applications.

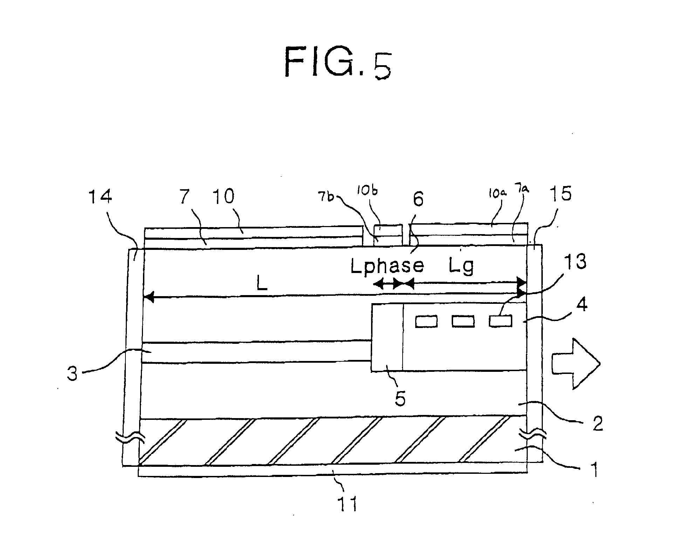

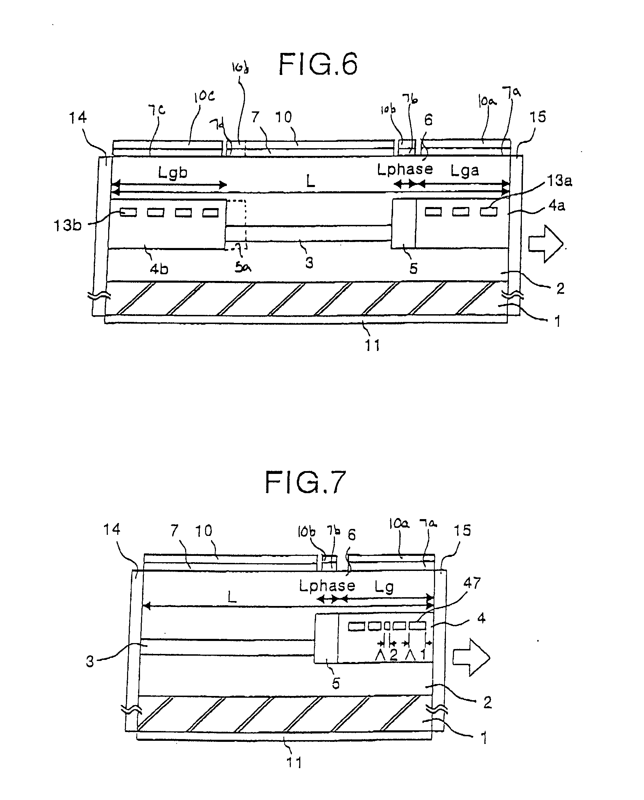

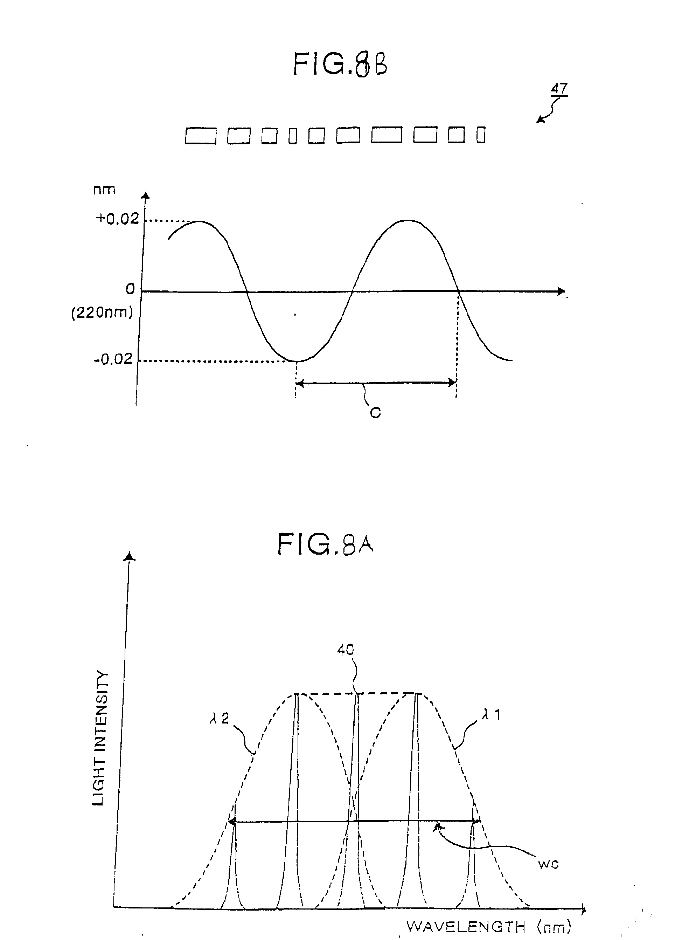

Figure 5 is a vertical sectional view in the longitudinal direction of the semiconductor laser device according to a second embodiment of the present invention. The second embodiment of the invention includes all of the components of the first embodiment which were described with respect to Figure 1 and these descriptions are not repeated here. However, as seen in Figure 5, the second embodiment also includes a phase matching portion interposed between the active region and the wave selection region. Specifically, the phase matching region includes the n-InP substrate 1 having the n-InP buffer layer 2, a light guiding wavepath layer 4, and p-InP cladding layer 6 sequentially stacked on a face (100) of the substrate 1. Moreover, where phase tuning is desired for the phase matching portion, a p-InGaAsP contact layer 7a and a p-side electrode 10b may optionally be provided as shown in Figure 6. The present inventors have discovered that the phase selection region allows for more efficient and stable operation of the semiconductor laser device.

Specifically, the present inventors discovered that while a laser according to the first embodiment provides a greater design margin for an efficient, stable and possibly tunable laser output, the different refractive indices of the active region and the wavelength selection region cause a phase mismatch at the boundary between these layers. This phase mismatch causes destructive interference resulting in lower output power. That is, light traveling from the reflective film 14 toward the reflective film 15 first travels through the active layer 3 having a first refractive index, and then through the wavepath layer 4 having a second refractive index. The portion of the light reflected the diffraction grating 13 and the antireflection film 15 travels through the wavepath layer 4 back towards the high reflection film 14. Because the refractive index of the wavepath layer 4 is different than the active layer 3, this returning light may be out of phase with the light being generated by the active layer causing destructive interference. This reduces the output of the device and causes unstable multiple-mode operation such as longitudinal mode hopping that causes a kink in the current versus optical output curve (IL curve) of the device. However, with the phase selection region of the second embodiment shown in Figure 5, the material of the layer 5 may be selected to provide a phase matching between the active region and the wavelength selection region. Moreover, where electrode 10b is provided in the phase matching region, the current in this region may be independently controlled to change the refractive index of the material 5 thereby adjusting the phase of a lightwave traveling through this material. That is, by changing the current in the phase matching region, the refractive index of the material 5 changes, thereby providing phase matching between the active region and the wavelength selecting portion of the semiconductor laser device.

Figure 6 is a vertical sectional view in the longitudinal direction of the semiconductor laser device according to a third embodiment of the present invention. The third embodiment of the invention includes all of the components of the second embodiment which were described with respect to Figure 5 and therefore are not described here. However, as seen in Figure 6, the third embodiment includes a second diffraction grating within a light guiding wavepath on the light reflecting side of the semiconductor laser device. Specifically, the region of the second light guiding wavepath includes the n-InP substrate 1 having the n-InP buffer layer 2, a light guiding wavepath layer 4b, the p-InP cladding layer 6, and optional p-InGaAsP contact layer 7c, and p-side electrode 10c sequentially stacked on a face (100) of the substrate 1. A diffraction grating 13b of a p-InGaAsP material is periodically formed within the wavepath layer 4b. The diffraction grating 13b of the embodiment of Figure 6 has a length Lgb. As with the diffraction grating on the light emitting side, it is desirable that the diffraction grating 13b be placed in contact with the reflective film 14, however, it is not absolutely necessary for them to be placed in contact therewith, and it is also possible for them to be placed within the range where they fulfill the functions of the diffraction gratings 13b. Moreover, it is preferable that the diffraction grating 13b has a reflectivity of at least 80% and the reflective film 14 is an antireflective film that substantially prevents reflections from the laser facet.

Application 09/983,249 incorporated herein discloses various techniques for placing the diffraction grating on the light reflecting side of the resonant cavity to achieve improved output efficiency of the laser device. While the techniques of this application are applicable to the device of Figure 6, the present invention improves over these devices by providing the grating structure in a DBR configuration which the present inventors discovered provides the unique advantages described above. Moreover, the current in the light reflecting grating can be made independently controllable. Applicants have discovered that by changing the current in the light reflecting grating region, the refractive index of the material 13b changes, thereby providing another degree of adjustment of the wavelength oscillation profile. Moreover, the wavepath layer 4b may be positioned adjacent to a second phase selection region 5b shown in phantom in Figure 6. When the second phase selection region is used, an electrically independent electrode is provided for the second phase selection region as illustrated by contact layer 7d and electrode 10d also shown in phantom in Figure 6.

In each of the embodiments previously described, the diffraction grating has a constant grating period. In yet another embodiment of the present invention, the wavelength oscillation profile 30 is manipulated by varying the period of the diffraction grating. Referring again to Figure 4, the present inventors have realized that the wavelength oscillation profile 30 is shifted toward a longer wavelength where the width of the grating elements (i.e. the grating period) is increased. Similarly, the wavelength oscillation profile 30 is shifted toward a shorter wavelength where the grating period is decreased. Based on this realization, the present inventors have discovered that a chirped diffraction grating, wherein the grating period of the diffraction grating 13 is periodically changed, provides at least two oscillation profiles by the same laser device. These two oscillation profiles combine to provide a composite profile having a relatively wide predetermined spectral width w thereby effectively increasing the number of longitudinal modes within the predetermined spectral width w.

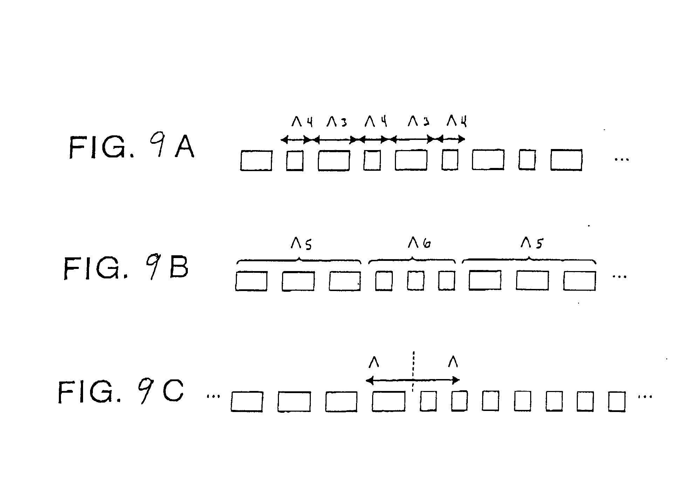

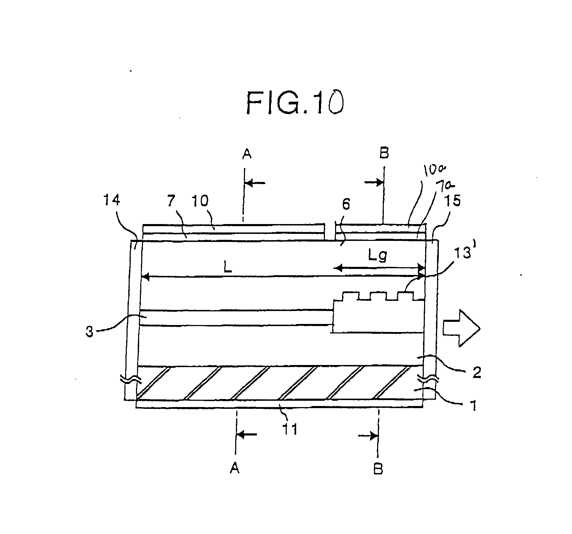

Figure 7 is a vertical sectional view in the longitudinal direction illustrating a general configuration of a semiconductor laser device having a chirped diffraction grating. As seen in this figure, diffraction grating 47 is positioned on the light emission side of the laser device and is made to include at least two grating periods Λ₁ and Λ₂. Figure 8 is a graph illustrating the principle of a composite oscillation wavelength spectrum produced by the combined period Λ₁ and Λ₂ of Figure 7, As seen in Figure 8A, an oscillation wavelength spectrum corresponding to Λ₁ is produced at a longer wavelength than the oscillation wavelength spectrum corresponding to Λ₂ since the period Λ₁ is larger than Λ₂. Where these individual oscillation wavelength spectrums are made to overlap such that a short wavelength half power point of the spectrum of Λ₁ is at a shorter wavelength than a long wavelength half power point of the spectrum of Λ₂, a composite oscillation wavelength spectrum 40 is formed as shown in Figure 8A. This composite spectrum 40 defines a composite spectrum width wc to thereby effectively widen the predetermined spectral width of wavelength oscillation spectrum to include a larger number of oscillation longitudinal modes.

Figure 8B illustrates a periodic fluctuation of the grating period of the diffraction grating 47. As shown in Figure 8B, the diffraction grating 47 has a structure in which the average period is 220 nm and the periodic fluctuation (deviation) of ±0,02 nm is repeated in the period C. Although the chirped grating is the one in which the grating period is changed in the fixed period C in the above-mentioned embodiment, configuration of the present invention is not limited to this, and the grating period may be randomly changed between a period Λ₁ (220 nm + 0.02 nm) and a period Λ₂ (220 nm - 0.02 nm). Moreover, as shown in Figure 9A, the diffraction grating may be made to repeat the period Λ₃ and the period Λ₄ alternately. In addition, as shown in Figure 9B, the diffraction grating may be made to alternatively repeat the period Λ₅ and the period Λ₆ for a plurality of times respectively and may be given fluctuation. And as shown in Figure 9C, the diffraction grating may be made to have a plurality of successive periods Λ₇ followed by plurality of successive periods Λ₈.

In each of the embodiments previously described, the grating material is shown embedded in a GaInAsP wavepath layer 4; however, the present invention is not limited to this structure. Figure 10 is a cross-sectional view of a semiconductor laser device having a diffraction grating embedded in the cladding layer in accordance with an embodiment of the invention. Figure 10 includes the features described with respect to Figure 1 except the configuration of the grating. Specifically, the grating 13' of Figure 10 is not provided within a background wavepath layer; the wavepath layer has corrugation and the grating is provided by difference of refractive index between wavepath layer and cladding layer 6.

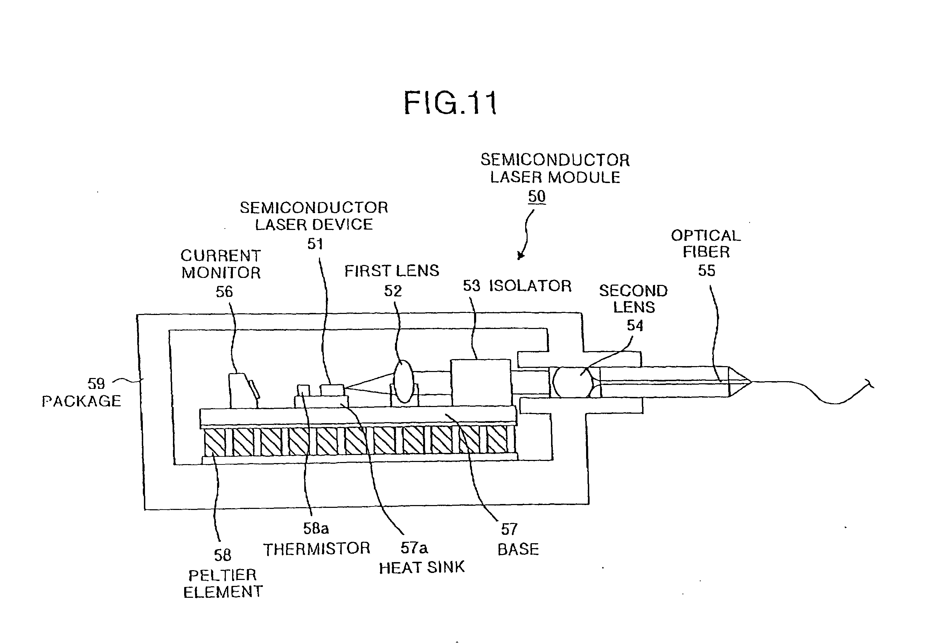

Figure 11 is a vertical sectional view illustrating the configuration of a semiconductor laser module having a semiconductor laser device according to the present invention. The semiconductor laser module 50 includes a semiconductor laser device 51, a first lens 52, an internal isolator 53, a second lens 54 and an optical fiber 55. Semiconductor laser device 51 is an integrated grating device configured in accordance with any of the above-described semiconductor laser devices and a laser beam irradiated from the semiconductor laser device 51 is guided to optical fiber 55 via first lens 52, internal isolator 53, and second lens 54. The second lens 54 is provided on the optical axis of the laser beam and is optically coupled with the optical fiber 55.

The semiconductor laser device 51 is preferably provided in a junction down configuration in which the p-side electrode is joined to the heat sink 57a, which is mounted on the base 57. A back facet monitor photo-diode 56 is also disposed on a base 57 which functions as a heat sink and is attached to a temperature control device 58 mounted on the metal package 59 of the laser module 50. The back facet monitor photo-diode 56 acts as a current monitor to detect a light leakage from the reflection coating side of the semiconductor laser device 51. This monitor current is used to control the light output of the laser module to thereby control the gain of the Raman amplifier.

The temperature control device 58 is a Peltier module. Although current (not shown) is given to the Peltier module 58 to perform cooling and heating by its polarity, the Peltier module 58 functions mainly as a cooler in order to prevent an oscillation wavelength shift by the increase of temperature of the semiconductor laser device 51. That is, if a laser beam has a longer wavelength compared with a desired wavelength, the Peltier element 58 cools the semiconductor laser device 51 and controls it at a low temperature, and if a laser beam has a shorter wavelength compared with a desired wavelength, the Peltier element 58 heats the semiconductor laser device 51 and controls it at a high temperature. By performing such a temperature control, the wavelength stability of the semiconductor laser device can improved. Alternatively, a thermistor 58a can be used to control the characteristics of the laser device. If the temperature of the laser device measured by a thermistor 58a located in the vicinity of the laser device 51 is higher, the Peltier module 58 cools the semiconductor laser device 51, and if the temperature is lower, the Peltier module 58 heats the semiconductor laser device 51. By performing such a temperature control, the wavelength and the output power intensity of the semiconductor laser device are stabilized.

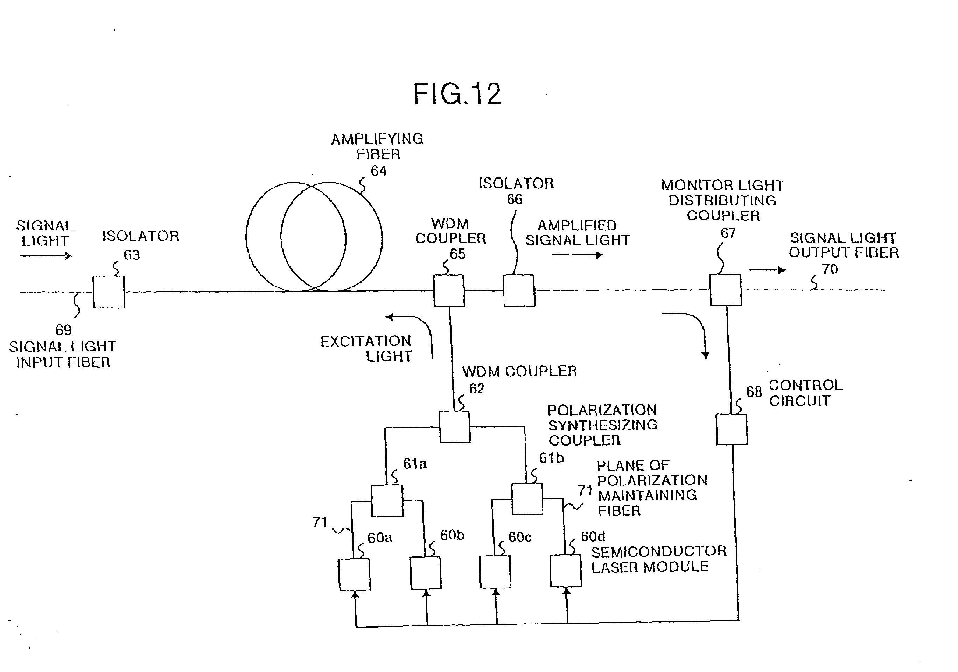

Figure 12 is a block diagram illustrating a configuration of a Raman amplifier used in a WDM communication system in accordance with the present invention. In Figure 12, semiconductor laser modules 60a through 60d are of the type described in the embodiment of Figure 11. The laser modules 60a and 60b output laser beams having the same wavelength via polarization maintaining fiber 71 to polarization-multiplexing coupler. Similarly, laser beams outputted by each of the semiconductor laser modules 60c and 60d have the same wavelength, and they are polarization-multiplexed by the polarization-multiplexing coupler 61 b. Each of the laser modules 60a through 60d outputs a laser beam having a plurality of oscillation longitudinal modes in accordance with the present invention to a respective polarization-multiplexing coupler 61a and 61b via a polarization maintaining fiber 71.

Polarization-multiplexing couplers 61a and 61b output polarization-multiplexed laser beams having different wavelengths to a WDM coupler 62. The WDM coupler 62 multiplexes the laser beams outputted from the polarization multiplexing couplers 61a and 61b, and outputs the multiplexed light beams as a pumping light beam to amplifying fiber 64 via WDM coupler 65. Signal light beams to be amplified are input to amplifying fiber 64 from signal light inputting fiber 69 via isolator 63. The amplified signal light beams are Raman-amplified by being multiplexed with the pumping light beams and input to a monitor light branching coupler 67 via the WDM coupler 65 and the polarization-independent isolator 66, The monitor light branching coupler 67 outputs a portion of the amplified signal light beams to a control circuit 68, and the remaining amplified signal light beams as an output laser beam to signal light outputting fiber 70.

The control circuit 68 controls a light-emitting state, for example, an optical intensity, of each of the semiconductor laser module 60a through 60d based on the portion of the amplified signal light beams input to the control circuit 68. This optical intensity of the Raman amplifier output is used along with the monitor current photodiode 56 of the laser module in Figure 15 to control the output of the semiconductor lasers of each module. Thus, control circuit 68 performs feedback control of a gain band of the Raman amplification such that the gain band will be flat over wavelength.

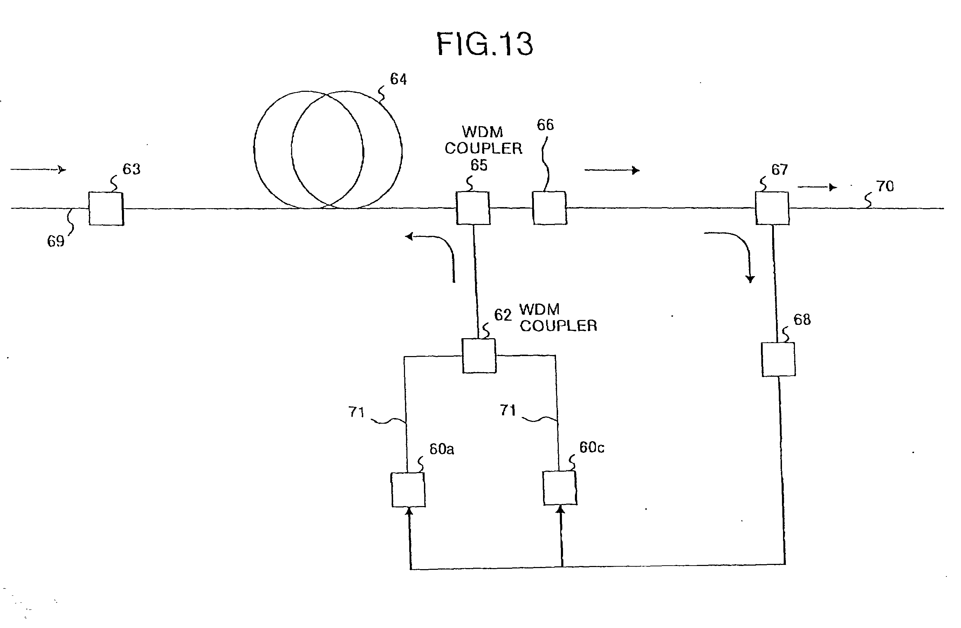

Although the Raman amplifier illustrated in Figure 12 is the backward pumping method, it is to be understood that the semiconductor laser device, module and Raman amplifier of the present invention may be used with a forward pumping method or the bi-directional pumping method. Moreover, the Raman amplifier can be constructed by wavelength-multiplexing of a plurality of pumping light sources which are not polarization-multiplexed. That is, the semiconductor laser module of the present invention can be used in a Raman amplifier where the polarization-multiplexing of pumping light is not performed. Figure 13 is a block diagram illustrating a configuration of a Raman amplifier in which polarization dependency is canceled by depolarizing a pumping light beam output from a single semiconductor laser device using polarization maintaining fibers as a depolarizer, in accordance with an embodiment of the present invention. As seen in this figure, laser modules 60A and 60C are directly connected to WDM coupler 62 via a polarization maintaining fiber 71. In this configuration, the angle of the polarization axis of the polarization maintaining fiber against the emitted light from semiconductor laser device is approximately 45 degrees.

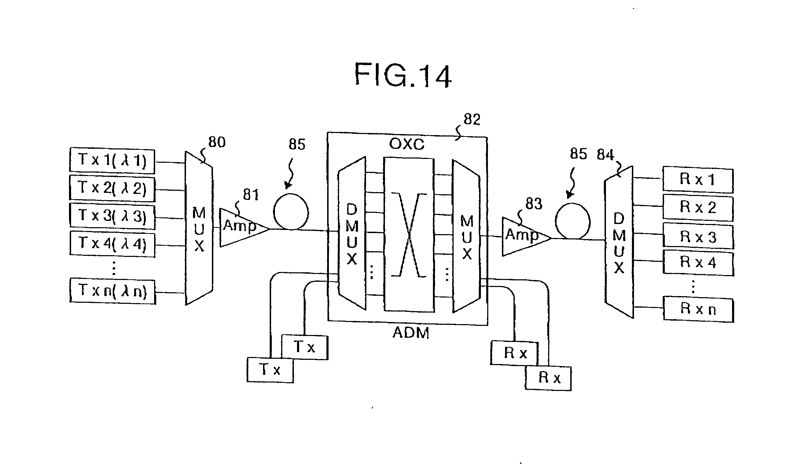

The Raman amplifier illustrated in Figures 12 and 13 can be applied to the WDM communication system as described above, Figure 14 is a block diagram illustrating a general configuration of the WDM communication system to which the Raman amplifier shown in either Figure 12 or Figure 13 is applied.

In Figure 14, optical signals of wavelengths λ₁ through λₙ are forwarded from a plurality of transmitter Tx₁ through Txₙ to multiplexing coupler 80 where they are wavelength-multiplexed and output to optical fiber 85 line for transmission to a remote communications unit. On a transmission route of the optical fiber 85, a plurality of Raman amplifiers 81 and 83 corresponding to the Raman amplifier illustrated in Figure 12 or Figure 13 arc disposed amplifying an attenuated optical signal. A signal transmitted on the optical fiber 85 is divided by an optical demultiplexer 84 into optical signals of a plurality of wavelengths λ₁ through λₙ, which are received by a plurality of receivers Rx₁ through Rxₙ. Further, an ADM (Add/Drop Multiplexer) may be inserted on the optical fiber 85 for inserting and removing an optical signal of an arbitrary wavelength.

Obviously, numerous modifications and variations of the present invention are possible in light of the above teachings. It is therefore to be understood that within the scope of the appended claims, the invention may be practiced otherwise than as specifically described herein. For example, the present invention has been described as a pumping light source for the Raman amplification, it is evident that the configuration is not limited to this usage and may be used as an EDFA pumping light source of the oscillation wavelength of 980nm and 1480nm.

## Claims

1. A semiconductor device comprising:
a light reflecting facet positioned on a first side of said semiconductor device;
a light emitting facet positioned on a second side of said semiconductor device thereby forming a resonator between said light reflecting facet and said light emitting facet;
an active layer configured to radiate light in the presence of an injection current, said active layer positioned within said resonator along a portion of the resonator length; and
a wavepath layer positioned adjacent to said active layer within a remaining portion of the resonator length, said wavepath layer including a diffraction grating configured to select a spectrum of light including multiple longitudinal modes.

2. The semiconductor laser device of Claim 1, wherein said wavepath layer is positioned adjacent to said light emitting facet.

3. The semiconductor laser device of claim 1, wherein said wavepath layer is positioned adjacent to said light reflecting facet.

4. The semiconductor laser device of claim 2 or 3, further comprising an injection current electrode positioned along said active layer and configured to input said injection current, wherein said current electrode does not extend a significant distance into said remaining portion of the resonator length.

5. The semiconductor laser device of claim 2 or 3, further comprising a phase adjustment layer positioned within said resonator along a portion of said resonator length interposed between said active layer and said wavepath layer, wherein said current electrode does not extend a significant distance into said portion of the resonator length interposed between the active layer and the wavepath layer.

6. The semiconductor device of claim 2 or 3, wherein said diffraction grating comprises a plurality of grating elements having a constant period.

7. The semiconductor device of claim 2 or 3, wherein said diffraction grating comprises a chirped grating having a plurality of grating elements having fluctuating periods.

8. The semiconductor device of claim 7, wherein said chirped grating is formed such that a fluctuation in the period of said plurality of grating elements is a random fluctuation.

9. A semiconductor laser device comprising;
means for radiating light from an active layer of said device in the presence of an injection current;
means for oscillating said radiated light within a cavity of said device; and
means for selecting a spectrum of said radiated light to be emitted by said semiconductor laser device, said spectrum of light including multiple longitudinal modes.

10. The semiconductor laser device of claim 9, further comprising means for inputting said injection current.

11. The semiconductor laser device of claim 9, further comprising means for adjusting a phase of said radiated light.

12. A semiconductor laser module comprising:
a semiconductor laser device comprising:
a light reflecting facet positioned on a first side of said semiconductor device,
a light emitting facet positioned on a second side of said semiconductor device thereby forming a resonator between said light reflecting facet and said light emitting facet,
an active layer configured to radiate light in the presence of an injection current, said active layer positioned within said resonator along a portion of the resonator length, and
a wavepath layer positioned adjacent to said active layer within a remaining portion of the resonator length, said wavepath layer including a diffraction grating configured to select a spectrum of light including multiple longitudinal modes as a laser beam for outputting from the laser device; and
a wave guide device for guiding said laser beam away from the semiconductor laser device.

13. An optical fiber amplifier comprising:
a semiconductor laser device comprising:
a light reflecting facet positioned on a first side of said semiconductor device,
a light emitting facet positioned on a second side of said semiconductor device thereby forming a resonator between said light reflecting facet and said light emitting facet,
an active layer configured to radiate light in the presence of an injection current, said active layer positioned within said resonator along a portion of the resonator length, and
a wavepath layer positioned adjacent to said active layer within a remaining portion of the resonator length, said wavepath layer including a diffraction grating configured to select a spectrum of light including multiple longitudinal modes as a laser beam for outputting from the laser device; and
an amplifying fiber coupled to said semiconductor laser device and configured to amplify a signal by using said light beam as an excitation light.

14. A wavelength division multiplexing system comprising:
a transmission device configured to provide a plurality of optical signals having different wavelengths;
an optical fiber amplifier coupled to said transmission device and including a semiconductor laser device comprising:
a light reflecting facet positioned on a first side of said semiconductor device,
a light emitting facet positioned on a second side of said semiconductor device thereby forming a resonator between said light reflecting facet and said light emitting facet,
an active layer configured to radiate light in the presence of an injection current, said active layer positioned within said resonator along a portion of the resonator length, and
a wavepath layer positioned adjacent to said active layer within a remaining portion of the resonator length, said wavepath layer including a diffraction grating configured to select a spectrum of light including multiple longitudinal modes as a laser beam for outputting from the laser device; and
a receiving device coupled to said optical fiber amplifier and configured to receive said plurality of optical signals having different wavelengths.

15. A Raman amplifier comprising:
a semiconductor laser device comprising:
a light reflecting facet positioned on a first side of said semiconductor device,
a light emitting facet positioned on a second side of said semiconductor device thereby forming a resonator between said light reflecting facet and said light emitting facet,
an active layer configured to radiate light in the presence of an injection current, said active layer positioned within said resonator along a portion of the resonator length, and
a wavepath layer positioned adjacent to said active layer within a remaining portion of the resonator length, said wavepath layer including a diffraction grating configured to select a spectrum of light including multiple longitudinal modes as a laser beam for outputting from the laser device; and
a fiber coupled to said semiconductor laser device and configured to carry a signal that is amplified based on said light beam being applied to said fiber.

16. The Raman amplifier of claim 15, wherein said semiconductor laser device is coupled to said fiber at an input side of said fiber such that said light beam is applied in a forward pumping method.

17. The Raman amplifier of claim 15, wherein said semiconductor laser device is coupled to said fiber at an output side of said fiber such that said light beam is applied in a backward pumping method.

18. The Raman amplifier of claim 15, wherein said semiconductor laser device is coupled to said fiber at an input and output side of said fiber such that said light beam is applied in both a forward and backward pumping method.
